(19) Europäisches Patentamt
European Patent Office
Office européen des brevets

(11) Publication number: **0 161 782**
**B1**

# (12) EUROPEAN PATENT SPECIFICATION

(45) Date of publication of patent specification: **09.11.88**

(51) Int. Cl.$^4$: **H 01 F 7/02**, G 01 N 24/06, A 61 B 5/06

(21) Application number: **85302389.3**

(22) Date of filing: **04.04.85**

## (54) Magnetic field generating device for NMR-CT.

(30) Priority: **11.05.84 JP 95075/84**
**11.05.84 JP 95076/84**
**11.04.84 JP 53575/84 u**
**11.04.84 JP 53576/84 u**
**01.06.84 JP 113713/84**
**15.11.84 JP 173377/84 u**
**15.11.84 JP 173378/84 u**
**09.02.85 JP 17418/85 u**
**12.03.85 JP 35708/85 u**
**12.03.85 JP 35710/85 u**

(43) Date of publication of application:
**21.11.85 Bulletin 85/47**

(45) Publication of the grant of the patent:
**09.11.88 Bulletin 88/45**

(84) Designated Contracting States:
**DE FR GB NL**

(56) References cited:
**WO-A-84/01226**
**DE-B-2 011 274**
**GB-A-1 454 754**
**JP-A-61 076 384**
**US-A-4 093 912**
**US-A-4 224 590**
**US-A-4 240 439**
**US-A-4 318 043**

(73) Proprietor: **SUMITOMO SPECIAL METALS CO., LTD.**
**22, Kitahama 5-chome Higashi-ku**
**Osaka-shi Osaka 541 (JP)**

(72) Inventor: **Miamoto, Toshinobu Yamazaki Seisakusho Sumitomo**
**Special Metal Co Ltd 15 to 17, 2- chome, Egawa**
**Shimamoto-cho Mishima-gun Osaka Pref. (JP)**
Inventor: **Sakurai, Hideya Yamazaki Seisakusho of Sumitomo**
**Special Metal Co Ltd 15 to 17, 2- chome, Egawa**
**Shimamoto-cho Mishima-gun Osaka Pref. (JP)**
Inventor: **Hayashi, Hiroo Yamazaki Seisakusho of Sumitomo**
**Special Metal Co Ltd 15 to 17, 2- chome, Egawa**
**Shimamoto-cho Mishima-gun Osaka Pref. (JP)**
Inventor: **Ohnishi, Youichi Yamazaki Seisakusho of Sumitomo**
**Special Metal Co Ltd 15 to 17, 2- chome, Egawa**
**Shimamoto-cho Mishima-gun Osaka Pref. (JP)**

(74) Representative: **Livsey, Gilbert Charlesworth Norris et al**
**HYDE, HEIDE & O'DONNELL 146 Buckingham Palace Road**
**London SW1W 9TR (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a magnetic field generating device employing a permanent magnet for use in a nuclear magnetic resonance-computerized tomography (hereinafter referred to as NMR-CT) to give a sectional image of a subjected being medically examined modulated in accordance with the properties of the tissue scanned and the invention in particular relates to a magnetic field generating device suitable for generating a strong, accurate, uniform magnetic field within a usefully large air gap.

In order to obtain a desired tomographic image of the human body by inserting the whole or a part of the body into an air gap in which a strong magnetic field, of the order of

1—10 KG (0.1−1 T),

is created, a uniformity and stability of the order of $10^{-4}$ or less is required for NMR-CT usage. As the magnetic field generating device for NMR-CT usage, a device are known which include a resistive electromagnet composed of cylindrically wound copper or aluminium coils, as are devices including a superconducting magnet which is cooled to near liquid helium temperature and which comprise special conductor coils.

The former type of device is relatively low-priced because of its construction, but it gives rise to problems; firstly in order to generate a sufficiently strong magnetic field, very large quantities of electric power and cooling water are consumed during operation, so the running cost is high, and secondly the available field strength is limited to around 0.15—0.20 T. On the other hand, the superconducting magnet of the latter type of device has the advantage that it can generate a stronger magnetic field with lower power consumption, but the capital cost of this device is much higher than that of more usual generators. Furthermore liquid helium, which is also expensive, is indispensable for achieving the superconducting condition so the total cost of the device is too high for use in a wide range of medical applications.

In comparison with the foregoing magnetic field generating devices employing a resistive electro-magnet or a superconducting magnet, a magnetic device field generating device employing a permanent magnet was suggested by OMR Co. and FONAR Co. in the RSNA in December, 1982. This suggested device, however, has about 100 tons total weight which seems to be too heavy for usual hospital usage.

There have been also proposed an alternative device of a construction in which a pair of circular ring-like permanent magnets magnetized in the axial direction are positioned with mutually opposing poles of different polarity with a spacing left therebetween (see JA-OS 61763/59, published April 9, 1984), a device of a structure wherein plural trapezoidal permanent magnets are arranged annularly (see JA-OS 501995/59, published November 29, 1984), and other devices. The former device is effective from the view point of costs, but has the drawback that its leakage flux is large because it creates a magnetic field more or less similar to that of the resistive electromagnet. On the other hand, the latter device is too complex in shape and too difficult to assemble for it to be a desirable system for practical permanent magnet processing.

Although a permanent magnet device is considered to be a truly ideal system for generating fields in NMR-CT applications, there have not been any actual devices which can provide the advantages of the permanent magnet due to the lack of sufficiently strong material being employed and enough attention given to the technology of suitable and practical designs.

It is a first object of the present invention to provide a practical device for NMR-CT which employs a permanent magnet as a magnetic field generating source and can create an excellently uniform, stable magnetic field within a required air gap.

It is a second object of the present invention to provide a device which includes an adjusting mechanism in order to control a uniform, stable magnetic field for NMR-CT.

It is a third object of the present invention to provide a device being small in size and excellent in practicability which employs an effectively arranged permanent magnet of an excellent magnetic property.

According to the present invention, there is provided a magnetic field generating device comprising a pair of permanent magnets magnetized in the same direction with mutually opposed poles of different-polarity arranged to define an air gap, said pair of permanent magnets being magnetically coupled together by a yoke to generate a magnetic field within said air gap, characterized by each of said permanent magnets being provided on its face opposing the other magnet, with a magnetic pole facing having an annular rib.

Preferably at least one inner projection is provided on said facing inside, and preferably concentric with, the annular rib.

In such a device, it is especially preferred that said pair of permanent magnets have a maximum energy product, $(BH)_{max}$, of not less than 30 MGOe (240 kJ/$m^3$).

Other preferred features of the invention are defined in claims 3 to 21 appearing below and the invention also extends to NMR-CT apparatus which is characterized in that it incorporates such magnetic field generating devices as are defined in any one of Claims 1 to 21 given below.

A construction in accordance with the present invention provides a practical device for NMR-CT which employs a permanent magnet as a magnetic field generating source and can create an excellently uniform, stable magnetic field within a required air gap.

The device can be small in size and excellent in practicability as compared with previously known devices suitable for use in the field of NMR-CT.

Various preferred embodiments of the invention will now be described by way of example with reference to the accompanying diagrammatic drawings in which:

Figure 1A is a diagrammatic cross-sectional view showing a first embodiment of a magnetic field generating device according to the present invention for use in NMR-CT;

Figures 1B and 1C are corresponding views showing other embodiments;

Figures 2A through 2D are enlarged sectional views showing embodiments of a magnetic pole facing;

Figures 3A through 3C are plan views showing other embodiments of the magnetic pole facing;

Figures 3D through 3F are central sectional views corresponding to Figures 3A through 3C, respectively;

Figures 4A through 4C are perspective views showing embodiments of a yoke;

Figure 5 is a central vertical sectional view showing a means for increasing the strength of magnetic field in the magnetic field generating device;

Figure 6 is a sectional view taken along line VI—VI in Figure 5;

Figure 7 is a central vertical sectional view showing another embodiment of the means shown in Figure 5;

Figure 8 is a sectional view showing the magnetic field generating device equipped with an adjusting mechanism to make variable the distance between a pair of magnetic pole facings;

Figure 9 is a central vertical sectional view showing another embodiment of the magnetic field adjusting mechanism;

Figure 10 is a sectional view taken along line X—X in Figure 9;

Figures 11 through 13 are central vertical sectional views showing further embodiments of the magnetic field adjusting mechanism;

Figure 14 is a sectional view taken along line XIV—XIV in Figure 13;

Figure 14A is a central vertical sectional view showing a still further embodiment of the mechanism shown in Figure 13; and

Figure 15 is a sectional view showing a further embodiment of the magnetic field generating device according to the present invention.

The embodiments of the present invention will be described with reference to Figures 1 through 15, in which the identical integers bear the same reference numbers.

Figure 1A is an explanatory view of a magnetic field generating device which has the structure according to the present invention, for use in an NMR-CT device. A pair of permanent magnets 1, 1 magnetized in the same direction are positioned so that their poles of different polarity are mutually opposed to leave an air gap 4 there-between. The respective opposing faces of the magnets 1, 1 carry magnetic pole facings 2, 2 each provided with an annular rib 5, and the pair of permanent magnets 1, 1 are magnetically coupled together by a yoke 3 to generate a magnetic field of 1 to 10 kG (0.1 to 1T) in strength within the air gap 4. Thus, medical examination can be performed by bringing the whole or a part of a human body into the air gap 4.

Although for the pair of permanent magnets 1, 1 there can be employed such as ferrite magnets, Alnico magnets, or rare earth cobalt magnets; it is preferable to employ permanent magnets of the Fe-B-R series (where R represents at least one of the rare earth elements and yttrium) which are permanent magnets of excellent property suggested previously by the present applicant (see Japanese Patent Application No. 57—145072) without including costly samarium; or cobalt, have a maximum energy product of a large value, and a temperature characteristic whose temperature coefficient of residual flux density (Br) is −0.07%/°C to −0.15%/°C. A notable property of this novel permanent magnet is that when cooled, especially to below 0°C, it can produce a remarkably high energy and can be utilized effectively. In order to cool down the permanent magnets 1, 1, a coolant *C* which may be a combination of alcohol-benzine and dry ice, or liquid nitrogen, is preferably provided on both side end faces.

In Fe-B-R magnets there may be present: R, (R being at least one of the rare earth elements and/or yttrium) in an amount of 8 to 30 atomic percent, boron, in an amount of 2 to 28 atomic percent, and iron in an amount of 42 to 90 atomic percent. The principal phase is in the tetragonal system. This Fe-B-R permanent magnet is a very good magnet showing a very large maximum energy product of the order of 30 MGOe (240 kJ/m$^3$) or more by inclusion of R (especially when chosen from the light rare earth element group inclusive of Nd and Pr), and with B and Fe as the principal components.

Because of the large air gap and high field requirement in the operation and usage envisaged, one pair of permanent magnets may be over 100 Kg in weight even if the foregoing Fe-B-R series permanent magnet is employed, if the requisite strength of magnetic field is to be achieved. Accordingly it is difficult to build the device using monolithic permanent magnets; generally, a considerable number of parts are built into a unitary magnetic block by an assembly process comprising the steps of magnetizing plural prism-like permanent magnets individually, and then assembling them into one unit. The form of the magnet may take any shape, such as circular disk-like or square plate-like, and may be selected appropriately depending upon the magnetic characteristic, the extent of the desired air gap 4, and other desired characteristics of the particular device under construction.

Each of the magnetic pole facings 2 has an outer diameter of $D_1$ and is formed at its periphery with an annular rib 5, of inner diameter $D_2$ and height H. By making them opposed to each other the uniformity of the magnetic field in the air gap 4 can be improved dramatically. If the inner face of the annular rib 5 is an upwardly expanding, for example conical, surface, further improvement in uniformity can be obtained.

Figure 2A through 2D are vertical sectional views showing different types of magnetic pole facings 2 to illustrate examples of various preferred rib sections. In particular, Figure 2A illustrates an annular rib which has a trapezoidal section, Figure 2B illustrates a triangular section rib, Figure 2C illustrates a triangular section rib, whose inner inclined face is curved, and Figure 2D illustrates a trapezoidal section whose corner portions have been chamfered to give a curved face.

The shape and size of the annular rib are also desirably selected in dependence upon the size and magnetic characteristics of the permanent magnet and the extent of the air gap. Specifically, the following range is most effective:

$$D_1 \leq 2.D_2, \text{ and } Lg \geq 4H$$

where $D_1$ is the magnetic pole facing outer diameter, $D_2$ is the annular rib inner diameter, Lg is the air gap, and H is the height of the annular rib.

Figures 3A through 3C illustrate further magnetic pole facings each having an annular rib 5, and a central inner projection 6 provided inside the annular rib and concentric with that annular rib 5.

Each inner projection 6 may be formed integrally on the exposed face of the magnetic pole facing; or a plate for example of iron may be bonded on a face of the magnetic pole facing. The projection 6 may be disk-like or square or it may be divided into a plurality of separate parts.

Figure 3A illustrates a disk-like inner projection 6 of substantially trapezoidal section (see Figure 3D) having an outer diameter $D_3$ and a height $H_3$, which has been formed integrally on the exposed face of the magnetic pole facing 2. Figure 3B illustrates an annular inner projection 6 also of substantially trapezoidal section (see Figure 3E) which is formed with a recess 6′ in its exposed face. The projection 6 and recess 6′ (when the latter is present are preferably concentric with the annular rib 5 and the projection may be integral with the remainder of the magnetic pole facing 2 as shown.

Each inner projection 6 may be formed with a single central recess 6′, and/or with one or more annular recesses again preferably concentric with the annular rib 5.

Figure 3C illustrates a inner projection 6 composed of plural disks of different diameters piled one on another (see Figure 3F), each having the same center as the annular rib 5 and having an outer-most diameter $D_3$ and a total height $H_3$ and positioned in the center portion.

Though in Figures 3A through 3C, only a trapezoidal annular rib 5 is illustrated, the annular rib 5 can take any shape, for example, a triangle in section, and such may be combined effectively with any of the foregoing inner projections 6 to give a desired function.

The shape and size of the inner projection and annular rib may also be selected appropriately depending upon the size and magnetic characteristic intended for the permanent magnet and the extent of air gap. Specifically, the following ranges are most effective:

$$D_1 \leq 2.D_2, \; Lg \geq 4H$$

and

$$100 \geq H/H_3 \geq 3$$

where $D_1$ is the magnetic pole facing outer diameter $D_2$ is the annular rib inner diameter, Lg is the gap, H is the height of the annular rib, and $H_3$ is the height of the inner projection.

The yoke 3 should be so constructed and arranged as to realize most effectively the formation of the magnetic path which extends between the pair of permanent magnets 1, 1 and as to reduce the weight of the device.

Figures 4A through 4C illustrate preferred embodiments of the yoke. Specifically, the yoke shown in Figure 4A comprises a cylindrical yoke portion 8 formed with an opening 7 for permitting the subject to be examined to be brought into the air gap. The ends of the yoke cylinder 8 are closed by yoke end portions 9, 9 each of which supports one of the paired permanent magnets on its inner face. Accordingly, because the air gap within which the magnetic field is created is surrounded by the yoke cylinder 8, there will be little leakage of flux spreading outward from the device, and the advantages of the magnetic field generating device employing a permanent magnet can be realized most effectively.

The yoke shown in Figure 4B has a structure in which two. plate-like yoke portions 10, 10 are positioned in opposition to each other and these are coupled together by plural rod-like yoke portions 11. A permanent magnet is to be provided on the inner face of each plate-like yoke portion 10. Thus the subject to be examined can be brought into the air gap 4 where the magnetic field is created, by being moved between the rod-like yoke portions 11 along any direction (four directions in the illustrated embodiment). Accordingly, manipulation, maintenance and management of any magnetic field adjusting mechanisms hereinafter described, as well as assembling of the device, can be performed easily, and the subject being examined is in a relatively unconfined space.

The plate-like yoke portion 10 is preferably made in the form of a square plate shape, disk plate shape, etc. depending upon the shape of permanent magnet. Further, the shape and number of the rod-like yoke portions 11 are desirably determined so as not to cause saturation of flux in the inside of the rod-like yoke portions 11.

The yoke shown in Figure 4C is composed of a quadrilateral tubular body which is open at 7 for insertion of the subject to be examined. The pair of permanent magnets are to be provided on the inner faces of upper and lower plate portions 12, 12.

In the following description of the embodiments in reference to Figure 1A and so forth, the

yoke 3 is assumed as having the form of a cylinder shape with top and bottom.

In the magnetic field generating device shown in Figure 1A, it is possible to improve the strength of the magnetic field within the air gap 4 by causing positive convergence of leakage of flux originating from the pair of magnetic pole facings 2, 2 into the air gap 4, this also contributing to reduction in size of the device. In order to achieve this advantage, the structures shown in Figures 5 through 7 are presented.

In Figures 5 and 6, on the outer periphery of the annular rib 5 of the magnetic pole facing 2, an annular permanent magnet 13 is provided for repelling the leakage of flux, and is made up of plurality of arcuate permanent magnets. Accordingly, the magnetic flux originating from the magnetic pole facings 2, 2 is caused to converge in the same direction as the magnetizing direction of the permanent magnets 1, 1 by means of the annular rib 5 and the parmanent magnet 13 repelling flux leakage is provided on the outer periphery of the former, thereby to create a magnetic field, so that the leakage of flux decreases and a magnetic field of a very high degree of uniformity is obtained within the air gap 4.

As will be described, a similar effect be obtained if the or each permanent magnet which repels the leakage of flux is appropriately located on the inner peripheral face of the yoke 3, for example, at a location opposite the outer peripheral face of each magnetic pole facing 2, or at a location opposite the center portion of the air gap 4.

The structure shown in Figure 7 is characterized in that each permanent magnet receiving portion 14 of the yoke 3 is displaced inwardly toward the air gap 4 so as to form a convex portion, thus distancing the periphery of the magnetic pole facing 2 from remaining portions of the magnet receiving face of the yoke 3. This structure can also improve the strength of magnetic field within the air gap 4 as is the case above.

Further, in the magnetic field generating device of the present invention, by the use of the magnetic field adjusting mechanism described hereinafter, a further uniform, stable magnetic field can be obtained, and maintenance and management becomes more easy.

Figure 8 illustrates a structure including an adjusting mechanism which renders the distance between the paired mutually opposing magnetic pole facings 2, 2 variable. In this drawing, the yoke 3 comprises two yoke end portions 9 on which the permanent magnets 1 are provided, and the cylinder-like yoke portion 8 is provided for magnetically coupling the yoke end portions 9. Each yoke end portion 9 is fitted in an upper or lower opening of the yoke cylinder 8. On the inner marginal peripheral face of each such opening of the yoke cylinder 8 a flange 15 is formed. Adjusting bolts 16 threaded through the plane marginal portion of the yoke end portion 9 at regular intervals have their ends abutting on the flange 15 to support the fitted yoke end portion 9. By turning the bolts 16, each yoke end portion 9 can be moved in the axial direction of the yoke cylinder 8, whereby the distance between the magnetic pole facings 2, 2 attached to the permanent magnets 1, 1 can be adjusted. This adjusting mechanism is also effective in adjusting finely the degree of parallelism of the pair of mutually opposing magnetic pole facings 2, 2.

By adjusting the distance between the paired magnetic pole facings 2, 2 in the vertical direction as viewed in the drawing, the substantial action of the magnetic flux originating from the permanent magnets 1, 1 on the gap can be regulated, and the extent of flux generation into the air gap 4 is uniformed and magnified. An excellently uniform magnetic field can be obtained with stability.

In the foregoing magnetic field adjusting mechanism, if the extent of variation in the distance between the magnetic pole facings is set large, a large-sized adjusting mechanism is needed because of the weight of the magnet and to avoid marring the contact surface on the yoke flange 15. If the extent of variation is set too short, there is little effect on the magnetic field. Accordingly, the extent of variation is preferable when it is over a range of 0.1% to 10% of a nominal design distance between the opposing faces.

Though other adjusting mechanisms, for example, for changing the length of the yoke which forms and maintains the air gap can be employed, a mechanism which directly influences the respective magnetic pole facings and which is magnetically equivalent in the magnetic circuit including that mechanism, is most desirable. Thus, the adjusting mechanism should desirably be selected in dependence upon the magnetic characteristic, shape and size of the permanent magnet, the size and shape of the yoke, the air gap size, and other desired characteritics of the particular device under construction.

The magnetic field adjusting mechanism shown in Figures 9 and 10 is characterized in that the pair of mutually opposing magnetic pole facings 2, 2 are permitted to move in parallel with respect to each other. In these drawings, nonmagnetic adjusting bolts 17 are threaded through the casing of the yoke 3, at three points, spaced by 120°, around the yoke 3 to bear on the periphery of each magnetic pole facing 2. By turning any of the adjusting bolts 17 at least one magnetic pole facing 2 can be moved in the direction parallel to its opposed magnetic pole facings.

In the foregoing structure, if, for example, one magnetic pole facing 2 is fixed and the other magnetic pole facing 2 is moved by turning the three adjusting bolts 17 so as to cause a change between the center lines of the paired opposed magnetic pole facings, a magnetic field which is uniform in the horizontal direction may be obtained within the air gap 4.

Besides the foregoing structure, several types of adjusting mechanisms can be employed according to the structure of the magnetic circuit, but, a mechanism which acts upon respective

magnetic pole facings which are magnetically equivalent in the magnetic circuit including that mechanism, is desirable. Thus, the adjusting mechanism should desirably be selected appropriately depending upon the magnetic characteristic, shape and size of the permanent magnet, the shape and size of the yoke, the extent of the air gap, and other desired characteristics of the particular device under construction.

However, if the extent of relative and parallel movement of the magnetic pole facings becomes larger than necessary, this causes several problems such as that the adjusting mechanism becomes large in size and complicated, and the magnetic balance is broken. Thus, the extent of parallel movement provided for is preferably 2% or less of the outer diameter of the magnetic pole facing.

Figure 11 illustrates another magnetic field adjusting mechanism in which at least one pair of magnetic field adjusting members made up of either magnetic material, and/or of permanent magnets, are provided on the yoke for variable contact with or insertion into the yoke and/or the paired permanent magnets 1, 1 by their movement in the magnetizing direction of the paired permanent magnets 1, 1.

As magnetic material for such magnetic adjusting members, are suitable soft magnetic materials such as structural carbon steel or electromagnetic soft iron, and magnetic shunt alloys such as 30 Ni-Fe or Ni-Cr-Fe. Such magnetic material adjusts the extent of shunting of the flux of the permanent magnet 1, thereby permitting fine adjustment of the strength of the magnetic field within the air gap 4. Specifically, in the case of the use of a magnetic shunt alloy, the extent of flux shunt is adjusted in response to a variation in ambient temperature about the device, so that a more stable magnetic field can be obtained. In the case of the use of a permanent magnet as the magnetic field adjusting member, this has the effect of changing the substantial mass of each of the paired permanent magnets 1, 1, so that the strength of the magnetic field within the air gap 4 can be adjusted finely.

In the foregoing adjusting mechanism, the magnetic field adjusting member does not necessarily come into contact with the permanent magnet 1, or come to a free-inserted state thereinto. A similar effective function can also be realized by changing the extent of contact or free-insertion with respect to the yoke portion where the permanent magnet 1 is provided.

Of course, the manner and extent of contact and free-insertion of the magnetic field adjusting member made up of soft magnetic material, magnetic shunt alloy, permanent magnet, etc may be selected appropriately depending upon the size and magnetic characteristic of the permanent magnet, the extent of the air gap, and other desired characteristics of the particular device under construction.

In Figure 11, plural holes 18 are bored in the permanent magnet 1 from the yoke 3 toward the magnetic pole facing. Into each hole 18 a rod-like soft magnetic material 19 is inserted so that its outer peripheral face is in contact with the inner peripheral face of the hole 18. A threaded support 20 is fixed on the upper face of the yoke 3 as to extend over the holes of the yoke 3, and an adjusting bolt 21 threaded through the support 20 carries the soft magnetic material 19. By adjusting the extent of vertical movement, as viewed in the direction of extent of the soft magnetic material 19, the degree of flux generation in the air gap 4 is regulated, thereby providing a favourable, stable uniform magnetic field.

The magnetic field adjusting mechanism shown in Figure 12 is characterized in that in order to enlarge the area of uniform magnetic field within the air gap 4, plural magnetic field adjusting bolts 22 made of magnetic material are provided, each of which projects from the yoke 3 and intrudes into the air gap 4 of the magnetic circuit so that the extent of intrusion is adjustable.

Specifically, the magnetic field adjusting bolts 22 are threaded through the casing the yoke 3 parallel to the opposing faces of the magnetic pole facings 2 at spots corresponding to an upper, middle and lower portions of the air gap 4 and at locations at the gap between the permanent magnet 1 and the yoke 3. Thus, by turning the bolts to move laterally as viewed in the drawing, the extent of projection into the gap can be adjusted.

The foregoing magnetic field adjusting bolt 22 has the function of shunting the flux generated in the air gap 4 and the like toward the yoke 3. Thus, by selecting appropriately the extent of projection into the air gap 4 and the like, the area of uniform magnetic field within the air gap 4 can be enlarged.

The shape, size, location and number of the magnetic field adjusting bolts, the projection-degree adjusting mechanism, etc. can be selected appropriately depending upon the structure of the magnetic field generating device, the size and magnetic characteristic of the permanent magnet, the extent of the air gap, and other desired characteristics of the particular device under construction.

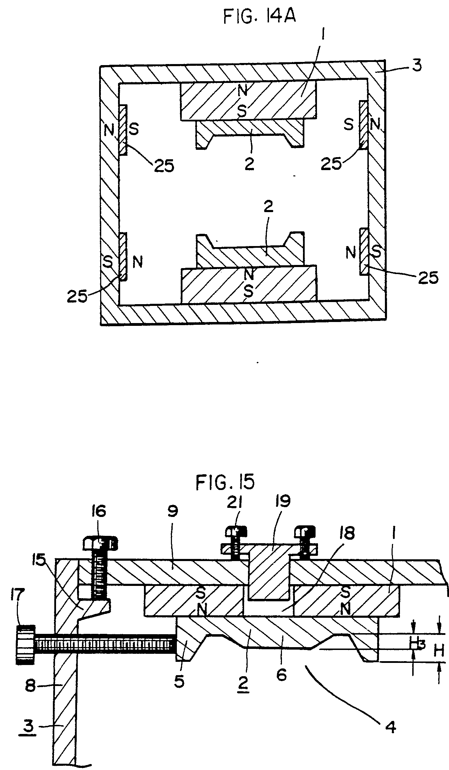

The magnetic field adjusting mechanism shown in Figures 13 and 14 is characterized in that one or more magnetic field adjusting permanent magnets are positioned and arranged inside the yoke so as to be movable towards and away from the fixed magnetic pole facings 2.

In these drawings, on the inner peripheral face of the yoke 3 opposing to the outer periphery of the annular rib 5 of each magnetic pole facing 2, annular leakage flux repelling permanent magnets 23 made of arcuate permanent magnets are provided at four points mutually spaced by 90°. Each magnet 23 is loosely coupled to the ends of bolt-like non-magnetic adjusting bolts 24 threaded through the casing of the yoke 3. Thus, by turning the adjusting bolts 24 the permanent magnet 23 is movable towards or away from the magnetic pole facing 2.

On the inner face of the arcuate leakage flux repelling permanent magnet 23 positioned in opposition to the periphery of the annular rib 5 of each magnetic pole facing 2, a magnetic pole is created whose polarity is the same as that of the corresponding magnetic pole facing 2. That is, in these drawings, the leakage flux repelling permanent magnet 23 opposed to the upper magnetic pole facing 2 of S-polarity, is also of S-polarity on its inner face, and is of N-polarity on its outer face, whereas the leakage flux repelling permanent magnet 23 positioned in opposition to the lower magnetic pole facing 2 is of N-polarity on its inner face.

In the foregoing structure, the magnetic flux originated from the magnetic pole facings 2, 2 is caused to converge by the leakage flux repelling permanent magnet 23 provided about the outer peripheral portions of the annular rib 5 and magnetic pole facing 2 in the same direction as the magnetizing direction of permanent magnets 1, 1, thereby to create a magnetic field. Thus, the leakage flux decreases and an excellently uniform magnetic flux can be obtained within the air gap 4.

If a leakage flux repelling permanent magnet 25 is secured on the inner face of the casing of the yoke 3 and its polarity is made identical to that of the corresponding magnetic pole facing 2, as shown in Figure 14A, a proper and appreciable effect can be obtained.

In the respective structures described hereinabove, although the leakage flux repelling permanent magnets 13, 24 and 25 (see Figures 5, 6, 13 and 14) and the permanent magnets employed as the magnetic field adjusting members (see Figure 11), other than the pair of permanent magnets, 1, 1, may be ferrite magnets, Alnico magnets, or rare earth magnets, as in the case of the paired permanent magnets 1, 1, it is preferable to employ an Fe-B-R series permanent magnet material for considerations of reduction in size of the device and the like. Further, in the case of any of the foregoing magnetic field adjusting mechanisms, the mechanism may be removed after the adjusting and assembling process has been completed or added each time it is required in view of maintenance and management.

Alternatively, or in addition, it is also effective, for very fine adjustment of the magnetic field to, coat each opposing face of the paired magnetic pole facings 2 with an appropriate amount of known magnetic paint, containing magnetite, maghemite, chromium dioxide, cobalt series ion oxide, metallic magnetic powder, etc. Such materials are known from the magnetic recording field, and are usually produced by incorporating magnetic particles in a binder material.

Also to be taken into consideration are variations of the magnetic field strength resulting from a variation in temperature of the permanent magnet caused by a variation in room temperature, by heating of shim coils for compensation of magnetic field, or in other ways. For example, as shown in Figure 1C, it is preferable to surround the magnetic pole facings 2 and permanent magnets 1 with a heat insulating layer *r*, made of expanded plastics material such as urea series, phenol or polyurethane, fibrous material such as tack wool, glass fibre or felt, natural material such as rubber or cork, metallic thin film such as aluminium sheet, refractory material such as asbestos or fire brick, or other heat stabilising material.

Further, in order to make easy removal of very fine magnetic dust and the like and for easy maintenance and management, it is also effective to provide detachably a non-magnetic cover made of stainless steel or the like on at least the magnetic pole facing portion.

It is also possible to make easy assembling of the heavy magnetic field generating device, levelling and adjusting of the magnetic pole facing, etc. by dividing the facing into plural pieces in at least one plane orthogonal to the central axis of the paired magnetic pole facings to an extent not harming the magnetic coupling.

It will be apparent that suitable combinations of the foregoing measures will be effective in achieving the objects of the present invention. Thus, an exceedingly uniform, stable magnetic field can be created within the air gap by selecting and assembling appropriately these various measures depending upon the magnetic characteristic of the permanent magnet, the extent of the air gap, and other desired characteristics of the particular device under construction, and the magnetic field generating device of easy maintenance and management can be provided.

The magnetic field generating device shown in Figure 15 is an embodiment which utilizes effectively a number of the foregoing respective measures, and this embodiment has produced a highly uniform magnetic field of 1.5 kG (0.15 T) in field strength and $2\times10^{-4}$ or less in uniformity inside a spherical space of 300 mm in diameter within the gap of 630 mm in inter-pole facing distance.

In this drawing, the symbol 1 indicates an annular permanent magnet of 1300 mm in outer diameter, 105 mm in thickness and of 35 MGOe (280 $kJ/m^3$) in $(BH)_{max}$, made of Fe-B-R series magnetic material and containing 15 atomic % of Nd, 8 atomic % of B, the remainder being substantially Fe.

In the center of the annular permanent magnet 1 is formed a hole 18 of 340 mm diameter to permit free insertion of a rod-like magnetic field adjusting member 19 made of structural carbon steel, hereinafter described.

The numeral 2 indicates a disk-like magnetic pole facing of 1150 mm in outer diameter, having an annular rib 5 of trapezoidal section which has an inner diameter $D_2$ of 850 mm and a height (H) of 94 mm. In its center portion, the pole facing 2 is provided with an inner projection 6 of a trapezoidal shape in section, which is 17 mm in height ($H_3$).

The symbol 3 indicates a cylindrical yoke of 1900 mm in overall diameter and 1375 mm in

height, composed of the pair of yoke end portions 9, 9 and the yoke cylinder 8.

The yoke end portion 9 is equipped on its inner face with the permanent magnet 1 and supports in the center portion the magnetic field adjusting member 19 via adjusting bolts 21 so that the member 19 can be adjusted in its extent of free insertion into the center hole 18 of the permanent magnet 1. The yoke end portion 9 is supported by adjusting bolts 16 abutting on the flange 15 formed on the inner peripheral face of the yoke cylinder 8 so that by turning the bolt 16 it can move in the axial direction of the yoke cylinder 8.

The symbol 17 indicates a non-magnetic adjusting bolt to shift the magnetic pole facing 2 parallel to an opposed magnetic pole facing, the facing 2 being disposed in a three point mounting with the bolts being mutually separated by 120° about the yoke cylinder 8.

Employing the foregoing structure and through adjustment of the magnetic field by the effective use of the respective adjusting mechanisms after assembling of the magnetic field generating device, an excellently uniform magnetic field as noted hereinbefore has been generated. By addition of a field compensating shim coil, the degree of uniformity of the magnetic field has been improved further to $1\times10^{-5}$ to $2\times10^{-5}$, whereby a distinct tomographic image has been obtained.

**Claims**

1. A magnetic field generating device comprising a pair of permanent magnets (1) magnetized in the same direction with mutually opposed poles of different-polarity arranged to define an air gap (4), and said pair of permanent magnets being magnetically coupled together by a yoke (3) to generate a magnetic field within said air gap (4), characterized by each of said permanent magnets (1) being provided on its face opposing the other magnet, with a magnetic pole facing (2) having an annular rib (5).

2. A magnetic field generating device as set forth in Claim 1, wherein said pair of permanent magnets (1) have a maximum energy product, $(BH)_{max}$, of not less than 30 MGOe (240 kJ/m$^3$).

3. A magnetic field generating device as set forth in either of claims 1 or 2, wherein at least one inner projection (6) is provided on said facing (2) inside, and preferably concentric with, the annular rib (5).

4. A magnetic field generating device as set forth in Claim 3, wherein said inner projection (6) has the following dimensional relationship:

$$100 \geq H/H_3 \geq 3$$

where H is the height of the annular rib (5) and $H_3$ is the height of the inner projection (6).

5. A magnetic field generating device as set forth in either of Claims 3 or 4, wherein said inner projection (6) is made up of substantially trapezoidal section, or is composed of plural disks of different diameter.

6. A magnetic field generating device as set forth in any of Claims 3 to 5, wherein said inner projection (6) is formed with at least one recess preferably concentric with the annular rib (5).

7. A magnetic field generating device as set forth in any preceding claim, wherein said annular rib (5) has the following dimensional relationships:

$$D_1 \leq 2.D_2, \text{ and } Lg \geq 4H$$

where $D_1$ is the outer diameter of the magnetic pole facing (2), $D_2$ is the inner diameter of the annular rib (5), Lg is the height (inter-pole facing distance) of the air gap (4), and H is the height of the annular rib (5).

8. A magnetic field generating device as set forth in any preceding claim, wherein the shape of said annular rib (5) is selected from a trapezoid in section, a triangle in section, and a shape whose inner inclined plane is curved.

9. A magnetic field generating device as set forth in any preceding claim, wherein said yoke (3) is cylindrical shape with closed ends, each end being provided with a said permanent magnet (1) affixed thereto.

10. A magnetic field generating device as set forth in any of claims 1 to 8, wherein two plate-like yoke portions (10) are arranged and disposed mutually in opposition and are coupled by plural rod-like yoke portions (11) to form said yoke (3), each of said plate-like yoke portions (10) being provided with a said permanent magnet (1) affixed thereto.

11. A magnetic field generating device as set forth in any of claims 1 to 8, wherein said yoke (3) is made up of a quadrilateral tubular body.

12. A magnetic field generating device as set forth in any preceding claim, wherein permanent magnet means (13) for repelling leakage of flux is disposed about the outer periphery of a said magnetic pole facing (2).

13. A magnetic field generating device as set forth in any preceding claim, wherein a permanent magnet means (25) for repelling leakage of flux is provided within said yoke (3).

14. A magnetic field generating device as set forth in any preceding claim, wherein at least one yoke face portion (14) adjacent said permanent magnet (1) is displaced inwardly (Figure 7) from remaining portions of that yoke face to distance the pole facing (2) of such magnet (1) from said remaining portions of the yoke face.

15. A magnetic field generating device as set forth in any preceding claim, wherein the distance between said paired mutually-opposing magnetic pole facings (2) is adjustable.

16. A magnetic field generating device as set forth in any preceding claim, wherein at least one of said paired mutually-opposed magnetic pole facings (2) is movable parallel with respect to its opposed facing.

17. A magnetic field generating device as set forth in any preceding claim, wherein at least one pair of magnetic field adjusting members (19)

made up of magnetic material and/or permanent magnet are provided on the yoke portions (3) where said paired permanent magnets (1) are disposed so that their extents of contact with, or of free insertion into, the yoke (3) or associated magnet (1), are variable in the magnetizing direction of said paired permanent magnets (1).

18. A magnetic field generating device as set forth in any preceding claim, wherein at least one magnetic field adjusting member (22) made of magnetic material is provided on said yoke (3) so that its extent of projection into said air gap (4) is variable.

19. A magnetic field generating device as set forth in any preceding claim, wherein at least one magnetic field adjusting permanent magnet (23) is movably mounted within said yoke (3) for approach to or separation from a said magnetic pole facing (2).

20. A magnetic field generating device as set forth in any preceding claim, wherein heat insulating material (*r*) is provided as to surround at least one of said permanent magnets (1) and magnetic pole facings (2).

21. A magnetic field generating device as set forth in any preceding claim, wherein said pair of permanent magnets (1) are maintained in coolant (*c*).

22. Nuclear magnetic resonance, computerized tomography apparatus characterized in that it incorporates a magnetic field generating device as defined in any one or more of the preceding claims.

**Patentansprüche**

1. Vorrichtung zur Erzeugung eines Magnetfeldes, bestehend aus einem Permanentmagnetepaar (1), magnetisiert in gleicher Richtung, mit wechselseitig gegenüberliegenden Polen unterschiedlicher Polarität angeordnet, um einen Luftspalt (4) zu begrenzen, und wobei das Permanentmagnetepaar magnetisch durch ein Joch (3) verbunden ist, um innerhalb des Luftspalts ein magnetisches Feld zu erzeugen, dadurch gekennzeichnet, daß jeder der Permanentmagnete (1) auf seiner dem anderen Magneten gegenüberliegenden Stirnseite mit einer magnetischen Polfläche (2) versehen ist, die eine ringförmige Rippe (5) aufweist.

2. Vorrichtung zur Erzeugung eines Magnetfeldes nach Anspruch 1, wobei das Permanentmagnetepaar (1) ein maximales Energieprodukt $(BH)_{max}$ von nicht weniger als 30 MGOe (240 kJ/$m^3$) aufweist.

3. Vorrichtung zur Erzeugung eines Magnetfeldes nach Anspruch 1 oder 2, wobei wenigstens ein innenliegender Vorsprung (6) auf der Polfläche (2) innerhalb der ringförmigen Rippe (5), vorzugsweise konzentrisch mit ihr, vorgesehen ist.

4. Vorrichtung zur Erzeugung eines Magnetfelds nach Anspruch 3 wobei der innere Vorsprung (6) das folgende Amessungsverhältnis aufweist:

$$100 \geq H/H_3 \geq 3,$$

wobei H die Höhe der kreisförmigen Rippe (5) und $H_3$ die Höhe des inneren Vorsprungs (6) ist.

5. Vorrichtung zur Erzeugung eines Magnetfeldes nach Anspruch 3 oder 4, wobei der innere Vorsprung (6) einen im wesentlichen trapezförmigen Querschnitt aufweist oder aus einer Mehrzahl von Scheiben mit unterschiedlichem Durchmesser zusammengesetzt ist.

6. Vorrichtung zur Erzeugung eines Magnetfeldes nach einem der Ansprüche 3 bis 5, wobei der innere Vorsprung (6) mit wenigstens einer Senke, vorzugsweise konzentrisch mit der ringförmigen Rippe (5), ausgebildet ist.

7. Vorrichtung zur Erzeugung eines Magnetfeldes nach einem der vorherigen Ansprüche, wobei die ringförmige Rippe (5) das folgende Abmessungsverhältnis aufweist:

$$D_1 \leq 2 \cdot D_2, \text{ und } Lg \geq 4H,$$

worin $D_1$ der äußere Durchmesser der magnetischen Polfläche (2), $D_2$ der innere Durchmesser der ringförmigen Rippe (5), und Lg die Höhe (Entfernung zwischen Polflächen) des Luftspalts (4) und H die Höhe der ringförmigen Rippe (5) ist.

8. Vorrichtung zur Erzeugung eines Magnetfeldes nach einem der vorhergehenden Ansprüche, wobei die Form der kreisförmigen Rippe (5) ausgewählt ist aus einem trapezförmigen Querschnitt, einen dreieckförmigen Querschnitt und einer Form, deren innere, geneigte Fläche geschwungen ist.

9. Vorrichtung zur Erzeugung eines Magnetfeldes nach einem der vorhergehenden Ansprüche, wobei das Joch (3) eine zylindrische Form mit geschlossenen Enden aufweist, wobei jedes Ende mit einem darauf befestigten Permanentmagneten (1) versehen ist.

10. Vorrichtung zur Erzeugung eines Magnetfeldes nach einem der Ansprüche 1 bis 8, wobei zwei plattenförmige Jochteile (10) angeordnet und sich gegenüberliegend gruppiert sind, und durch eine Anzahl stangenförmiger Jochteile (11) miteinander verbunden sind, um das Joch (3) zu bilden, wobei jedes der plattenförmigen Jochteile (10) mit einem daran befestigten Permanentmagneten (1) versehen ist.

11. Vorrichtung zur Erzeugung eines Magnetfeldes nach einem der vorhergehenden Ansprüche 1 bis 8, wobei das Joch (3) aus einem viereckigen, rohrförmigen Körper besteht.

12. Vorrichtung zur Erzeugung eines Magnetfeldes nach einem der vorhergehenden Ansprüche, wobei Permanentmagnetelemente (13) zur Verhinderung von Leckfluß an dem äußeren Umfang einer der magnetischen Polflächen (2) angeordnet sind.

13. Vorrichtung zur Erzeugung eines Magnetfeldes nach einem der vorhergehenden Ansprüche, wobei Permanentmagnetelemente (25) zur Verhinderung von Leckfluß innerhalb des Jochs (3) vorgesehen sind.

14. Vorrichtung zur Erzeugung eines Magnetfeldes nach einem der vorhergehenden Ansprüche, wobei wenigstens ein Teil (14) der Jochstirnfläche einwärts versetzt (Fig. 7) gegenüber den übrigen Teilen einer Jochfläche ist, die dem Permanentmagneten (1) benachbart sind, um die Polfläche (2) des Magneten (1) von den übrigen Teilen der Jochfläche zu beabstanden.

15. Vorrichtung zur Erzeugung eines Magnetfeldes nach einem der vorhergehenden Ansprüche, wobei die Entfernung zwischen den paarweise sich gegenüberstehend angeordneten magnetischen Polflächen (2) einstellbar ausgebildet ist.

16. Vorrichtung zur Erzeugung eines Magnetfeldes nach einem der vorhergehenden Ansprüche, wobei wenigstens eine der paarweise sich gegenüberliegend angeordneten magnetischen Polflächen (2) parallel zu der ihr gegenüberliegenden Stirnfläche beweglich ausgebildet ist.

17. Vorrichtung zur Erzeugung eines Magnetfeldes nach einem der vorhergehenden Ansprüche, wobei wenigstens ein Paar magnetischer Feldeinstellglieder (19) aus magnetischem Material und/oder ein Permanentmagnet auf den Teilen des Jochs (3) vorgesehen sind, wobei die Permanentmagnete (1) des Paares so angeordnet sind, daß die Größe ihres Kontaktes mit, oder ihr freies Eintauchen in das Joch (3) oder in den zugehörigen Magneten (1) in der Magnetisierungsrichtung der gepaarten Permamentmagnete (1) einstellbar ausgebildet sind.

18. Vorrichtung zur Erzeugung eines Magnetfeldes nach einem der vorhergehenden Ansprüche, wobei wenigstens ein magnetisches Feld-Einstellglied (22) aus magnetischem Material auf dem Joch (3) vorgesehen ist, so daß die Größe seines Eintauchens in den Luftspalt 4 einstellbar ist.

19. Vorrichtung zur Erzeugung eines Magnetfeldes nach einem der vorhergehenden Ansprüche, wobei wenigstens ein das magnetische Feld einstellender Permanentmagnet (23) beweglich innerhalb des Jochs (3) montiert ist, um sich einer der magnetischen Pol-Stirnflächen (2) zu nähern oder sich davon zu trennen.

20. Vorrichtung zur Erzeugung eines Magnetfeldes nach einem der vorhergehenden Ansprüche, wobei Wärmeisolationsmaterial (*r*) vorgesehen ist, um wenigstens einen der Permanentmagnete (1) und der magnetischen Polflächen (2) zu umgeben.

21. Vorrichtung zur Erzeugung eines Magnetfeldes nach einem der vorhergehenden Ansprüche, wobei das Permanentmagnetepaar (1) innerhalb eines Kühlmittels (*c*) gehalten wird.

22. Magnetischer Kernresonanz-Computer-Tomograph, dadurch gekennzeichnet, daß er eine Vorrichtung zur Erzeugung eines magnetischen Feldes aufweist, wie in einem oder mehreren der vorherigen Ansprüche definiert.

**Revendications**

1. Un dispositif de génération de champ magnétique comprenant une paire d'aimants permanents (1) aimantés dans la même direction, avec des pôles de polarité différente disposés mutuellement en regard pour définir un entrefer (4), et les aimants de cette paire d'aimants permanents étant placés en couplage magnétique mutuel par une culasse (3), pour produire un champ magnétique à l'intérieur de l'entrefer (4), caractérisé en ce que chacun des aimants permanents (1) comporte, sur sa face en regard de l'autre aimant, une pièce polaire magnétique (2) ayant une nervure annulaire (5).

2. Un dispositif de génération de champ magnétique selon la revendication 1, dans lequel les aimants de la paire d'aimants permanents (1) ont une énergie spécifique maximale, $(BH)_{max}$, qui n'est pas inférieure à 30 MGOe (240 kJ/m$^3$).

3. Un dispositif de génération de champ magnétique selon l'une quelconque des revendications 1 ou 2, dans lequel au moins une saillie intérieure (6) est formée sur la pièce polaire (2), à l'intérieur de la nervure annulaire (5), et de préférence en position concentrique avec cette dernière.

4. Un dispositif de génération de champ magnétique selon la revendication 3, dans lequel la saillie intérieure (6) présente la relation dimensionnelle suivante:

$$100 \geq H/H_3 \geq 3$$

dans laquelle H est la hauteur de la nervure annulaire (5) et $H_3$ est la hauteur de la saillie intérieure (6).

5. Un dispositif de génération de champ magnétique selon l'une quelconque des revendications 3 ou 4, dans lequel la saillie intérieure (6) a une section pratiquement trapézoïdale, ou bien est constituée par plusieurs disques de diamètre différent.

6. Un dispositif de génération de champ magnétique selon l'une quelconque des revendications 3 à 5, dans lequel la saillie intérieure (6) comporte au moins une cavité qui est de préférence concentrique par rapport à la nervure annulaire (5).

7. Un dispositif de génération de champ magnétique selon l'une quelconque des revendications précédentes, dans lequel la nervure annulaire (5) présente les relations dimensionnelles suivantes:

$$D_1 \leq 2\ D_2, \text{ et } Lg \geq 4H$$

dans lesquelles $D_1$ est le diamètre extérieur de la pièce polaire magnétique (2), $D_2$ est le diamètre intérieur de la nervure annulaire (5), Lg est la hauteur (distance entre les pièces polaires des deux pôles) de l'entrefer (4), et H est la hauteur de la nervure annulaire (5).

8. Un dispositif de génération de champ magnétique selon l'une quelconque des revendications précédentes, dans lequel la forme de la nervure annulaire (5) est sélectionnée parmi des formes correspondant à une section trapézoïdale ou une section triangulaire, et une forme dont la surface inclinée intérieure est courbe.

9. Un dispositif de génération de champ

magnétique selon l'une quelconque des revendications précédentes, dans lequel la culasse (3) a une forme cylindrique avec des extrémités fermées, avec un aimant permanent (1) fixé à chaque extrémité.

10. Un dispositif de génération de champ magnétique selon l'une quelconque des revendications 1 à 8, dans lequel deux parties de culasse en forme de plaque (10) sont disposées mutuellement en regard, et sont accouplées par plusieurs parties de culasse en forme de barreaux (11) pour former la culasse (3), et un aimant permanent (1) est fixé sur chacune des parties de culasse en forme de plaque (10).

11. Un dispositif de génération de champ magnétique selon l'une quelconque des revendications 1 à 8, dans lequel la culasse (3) est constituée par un corps tubulaire dont les faces sont des quadrilatères.

12. Un dispositif de génération de champ magnétique selon l'une quelconque des revendications précédentes, dans lequel des moyens à aimants permanents (13) destinés à repousser un flux de fuite sont disposés autour de la périphérie extérieure de la pièce polaire magnétique (2).

13. Un dispositif de génération de champ magnétique selon l'une quelconque des revendications précédentes, dans lequel des moyens à aimants permanents (25) destinés à repousser un flux de fuite sont placés à l'intérieur de la culasse (3).

14. Un dispositif de génération de champ magnétique selon l'une quelconque des revendications précédentes, dans lequel au moins une partie de la face de la culasse (14) qui est adjacente à l'aimant permanent (1) est décalée vers l'intérieur (figure 7) par rapport aux parties restantes de cette face de culasse, pour éloigner la pièce polaire (2) de cet aimant (1) par rapport aux parties restantes de la face de la culasse.

15. Un dispositif de génération de champ magnétique selon l'une quelconque des revendications précédentes, dans lequel la distance entre les deux pièces polaires magnétiques mutuellement en regard (2) est réglable.

16. Un dispositif de génération de champ magnétique selon l'une quelconque des revendications précédentes, dans lequel l'une au moins des deux pièces polaires magnétiques mutuellement en regard (2) peut être déplacée par rapport à la pièce polaire en regard.

17. Un dispositif de génération de champ magnétique selon l'une quelconque des revendications précédentes, dans lequel au moins une paire de pièces de réglage de champ magnétique (19) constituées par un matériau magnétique et/ou un aimant permanent, sont placées sur les parties de culasse (3) sur lesquelles se trouvent les deux aimants permanents (1), de façon que leurs étendues de contact avec la culasse (3) ou l'aimant associé (1), ou leur distance d'insertion libre dans la culasse ou l'aimant associé, soient variables dans la direction d'aimantation des deux aimants permanents (1).

18. Un dispositif de génération de champ magnétique selon l'une quelconque des revendications précédentes, dans lequel au moins une pièce de réglage de champ magnétique (22), formée par un matériau magnétique, est placée sur la culasse (3), de façon que sa distance de pénétration dans l'entrefer (4) sont variable.

19. Un dispositif de génération de champ magnétique selon l'une quelconque des revendications précédentes, dans lequel au moins un aimant permanent de réglage de champ magnétique (23) est monté de façon mobile à l'intérieur de la culasse (3) pour pouvoir être approché ou éloigné d'une pièce polaire magnétique (2).

20. Un dispositif de génération de champ magnétique selon l'une quelconque des revendications précédentes, dans lequel une matière d'isolation thermique (*r*) est placée de façon à entourer l'un au moins des éléments comprenant les aimants permanents (1) et les pièces polaires magnétiques (2).

21. Un dispositif de génération de champ magnétique selon l'une quelconque des revendications précédentes, dans lequel les aimants de la paire d'aimants permanents (1) sont maintenus dans un fluide de refroidissement (*C*).

22. Appareil de tomographie informatisée par résonance magnétique nucléaire, caractérisé en ce qu'il comprend un dispositif de génération de champ magnétique conforme à l'une quelconque ou à plusieurs des revendications précédentes.

FIG. 1A

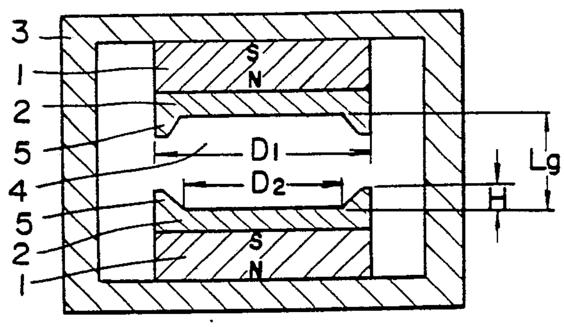


FIG. 1B

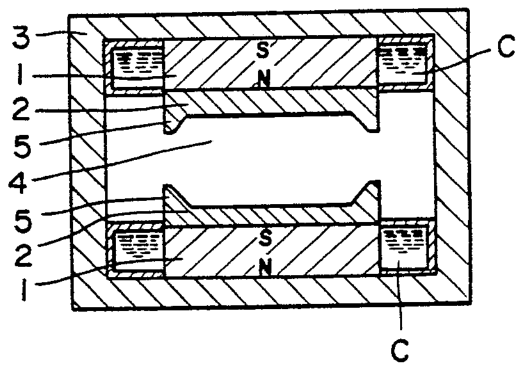


FIG. 1C

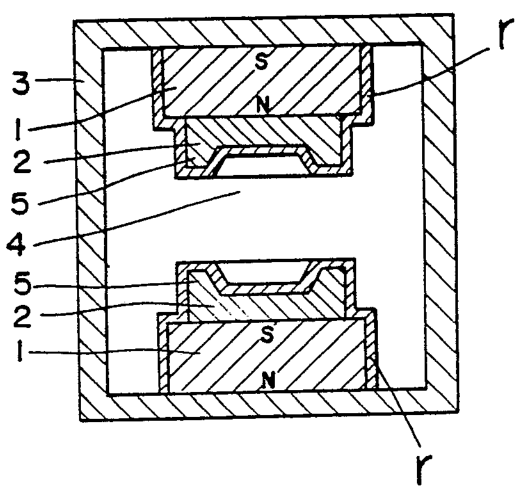

FIG.2A

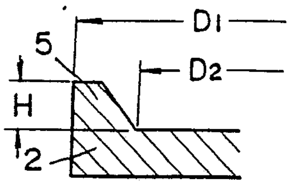


FIG.2B

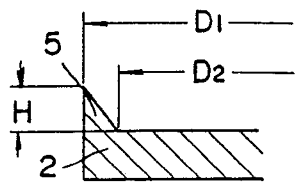


FIG.2C

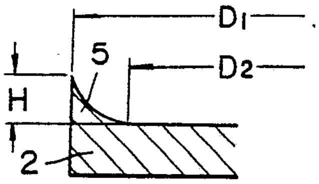


FIG.2D

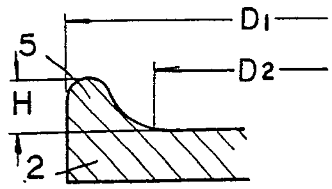


FIG.3A

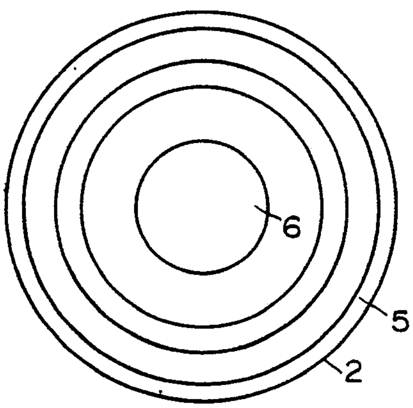


FIG.3B

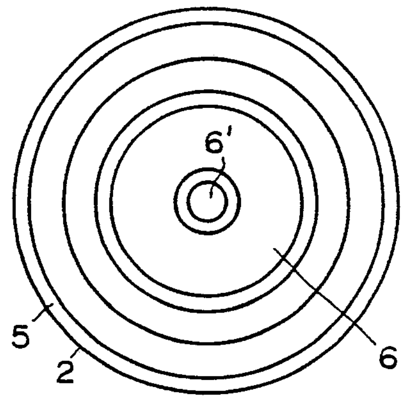


FIG.3D

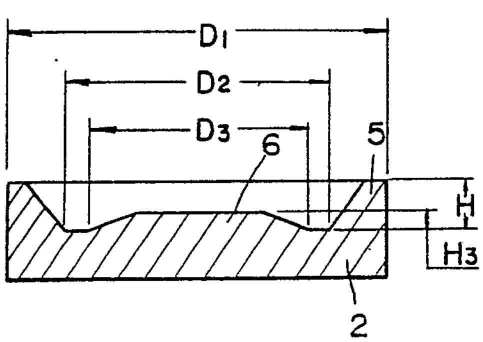


FIG.3E

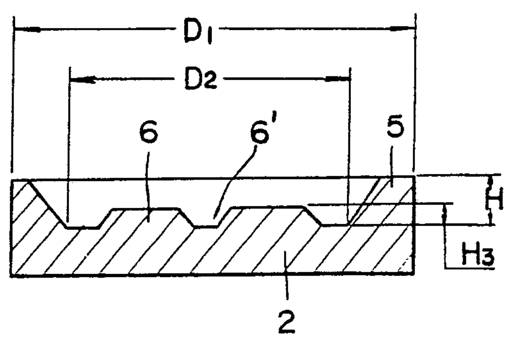

FIG. 3C

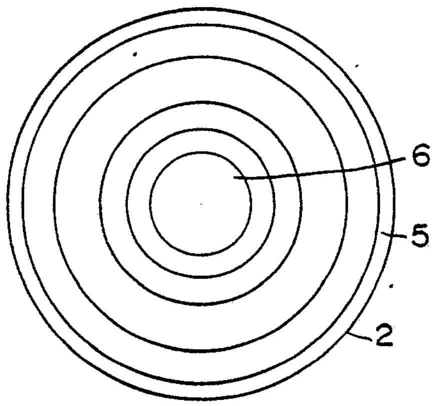


FIG. 3F

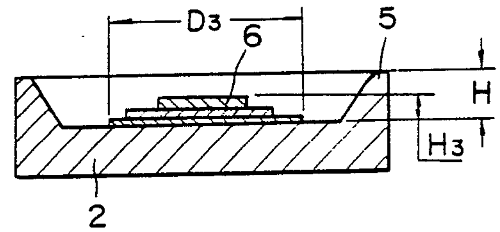


FIG. 4B

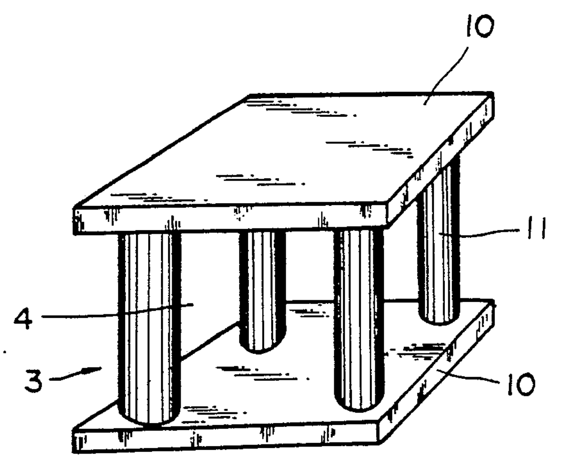


FIG. 4A

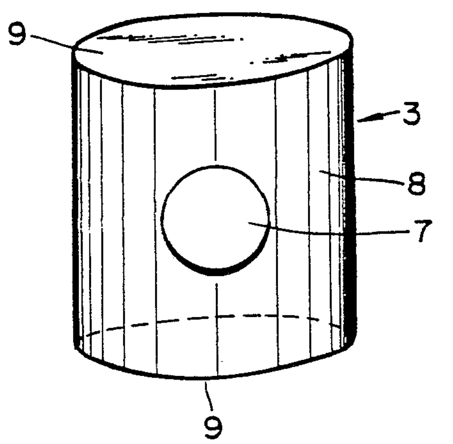


FIG. 4C

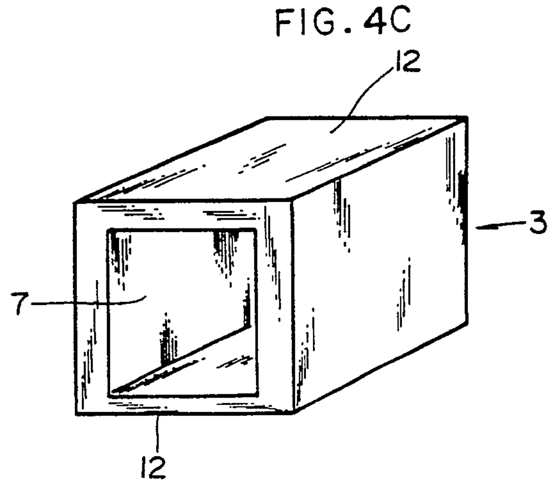

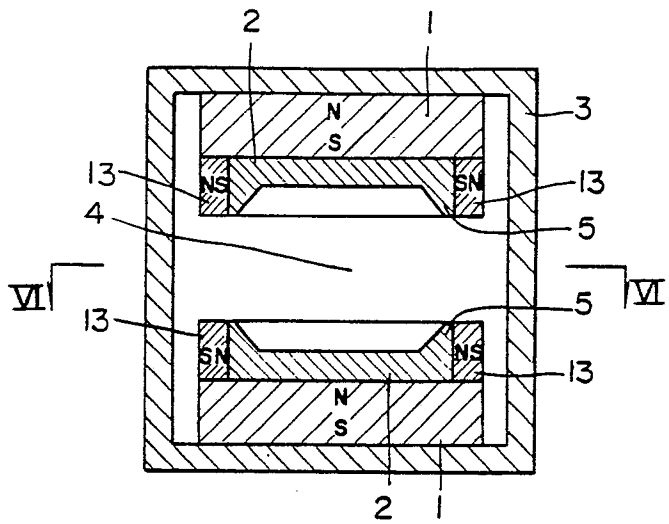
2
1
N
S
3
13
NS
SN
13
4
5
VI
VI
5
13
SN
NS
13
N
S
2
1

FIG. 6

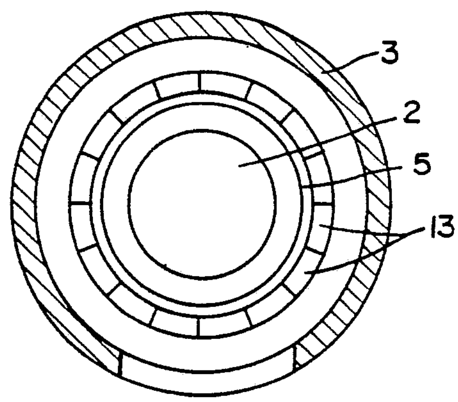
3
2
5
13

FIG. 7

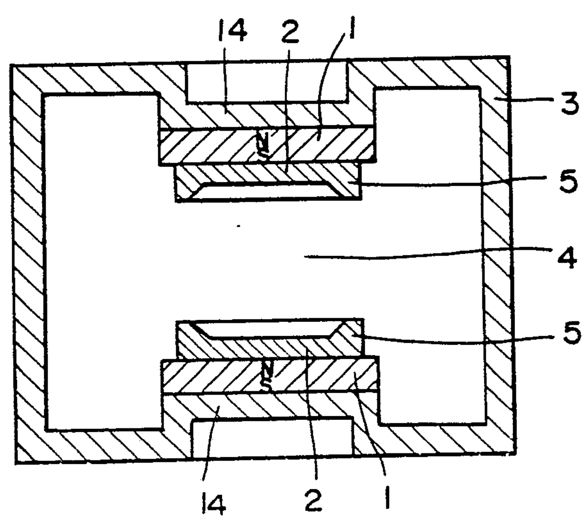
14
2
1
3
N
S
5
4
5
N
S
14
2
1

FIG. 8

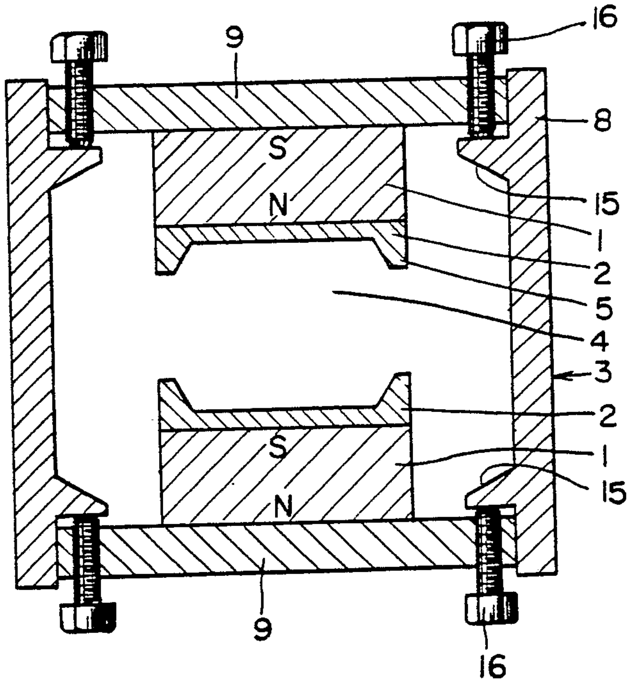


FIG. 9

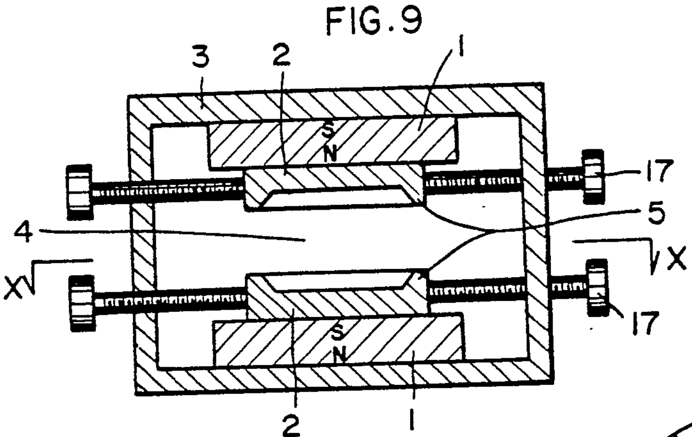


FIG. 10

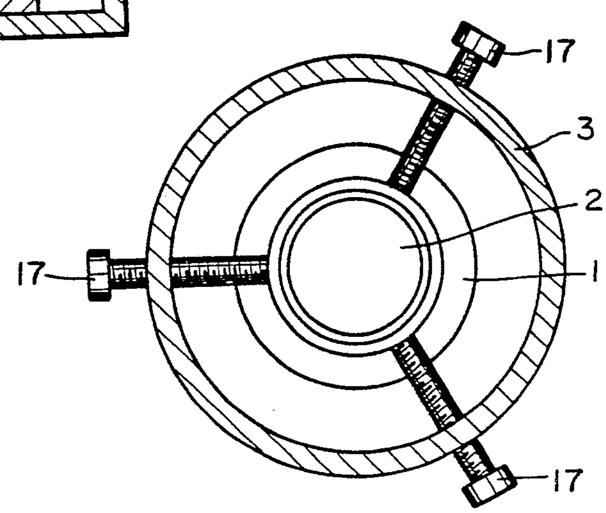

FIG. 11

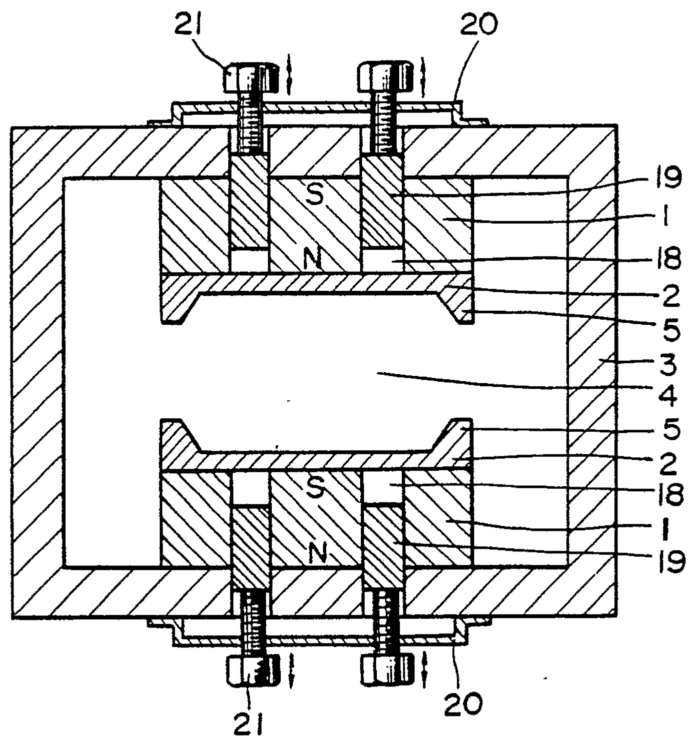


FIG. 12

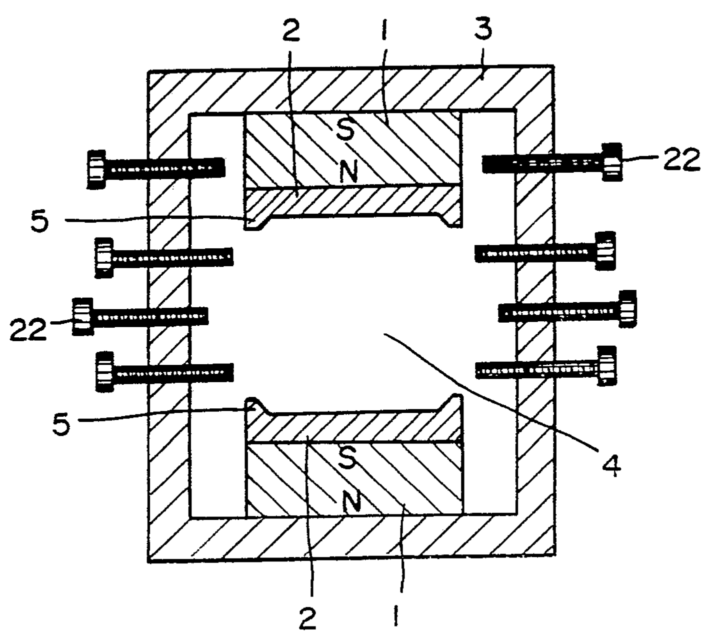

FIG.13

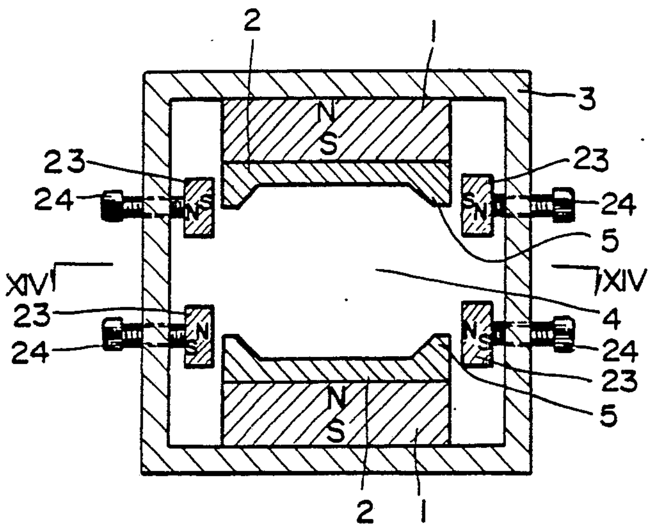


FIG.14

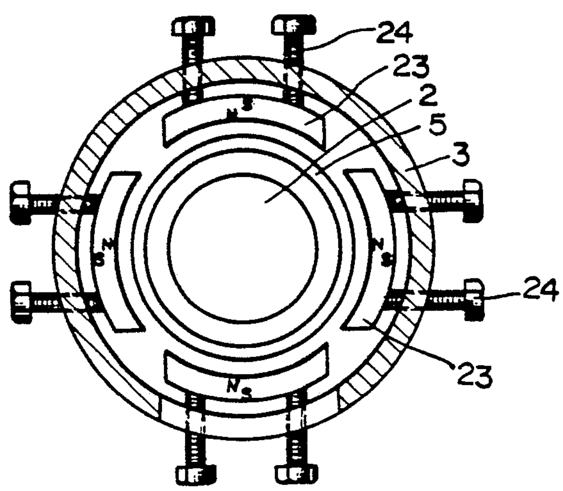

FIG. 14A

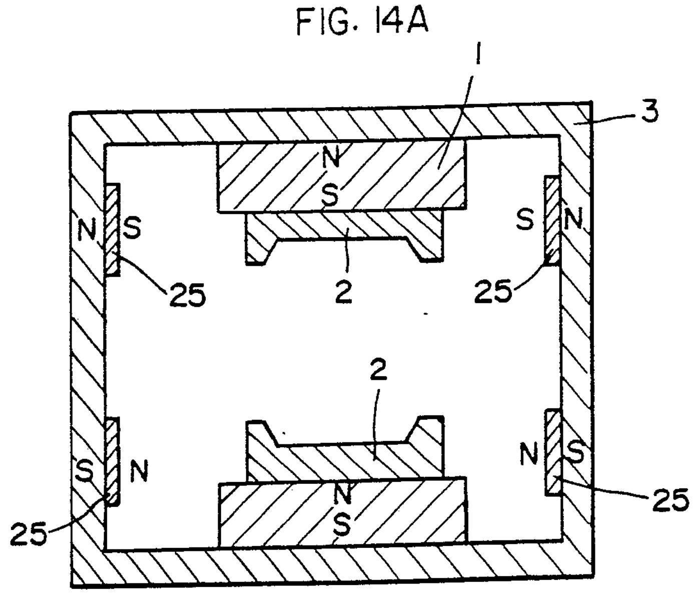


FIG. 15